# EUROPEAN PATENT SPECIFICATION

(11) **EP 1 432 116 B1**
(45) Date of publication and mention of the grant of the patent: **01.02.2006**
(21) Application number: 03257215.8
(22) Date of filing: 15.11.2003
(51) Int. Cl.: H03B 5/04, H03B 5/12

(54) **Oscillation circuit for television tuner**
Oszillatorschaltung für einen Fernsehtuner
Circuit oscillateur pour un tuner de télévision

(30) Priority: 20.11.2002 JP 2002336067
(43) Date of publication of application: 23.06.2004
(73) Proprietor: ALPS ELECTRIC CO., LTD., Ota-ku Tokyo 145 (JP)
(72) Inventor: Yamamoto, Masaki, Ota-ku, Tokyo 145 (JP)
(74) Representative: Kensett, John Hinton

(56) References cited:
- EP-A- 0 351 153
- EP-A- 0 660 506
- US-A- 4 479 259
- US-A- 5 144 263
- US-A- 5 859 674
- US-A- 6 097 258

## Description

The invention relates to an oscillation circuit for a television tuner.

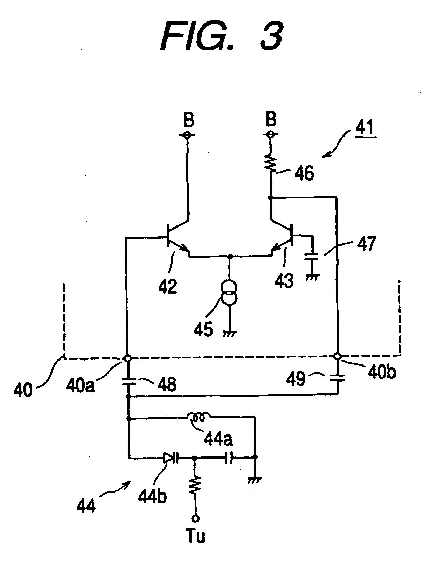

Fig. 3 shows a conventional oscillation circuit for a television tuner. Fig. 3 shows an oscillation circuit 41 used for example for a VHF television tuner for low band or high band, and the oscillation circuit includes first and second oscillation transistors 42 and 43 provided in an integrated circuit 40 and a resonance circuit 44 provided outside the integrated circuit 40. The first and second oscillation transistors 42 and 43 have their emitters connected with each other and then together to a constant current source 45. The first oscillation transistor 42 has its collector connected to the power supply terminal B of the integrated circuit 40, and the second oscillation transistor 43 has its collector connected to the power supply terminal B through a feeding resistor 46. The second transistor 43 has its base grounded in terms of high frequencies by a ground capacitor 47 in the integrated circuit 40.

Therefore, the first and second oscillation transistors 42 and 43 are differentially connected, and the base of the first oscillation transistor 42 and the collector of the second oscillation transistor 43 are in phase.

The integrated circuit 40 is provided with first and second terminals 40a and 40b, the first terminal 40a is connected with the base of the first oscillation transistor 42, and the second terminal 40b is connected with the collector of the second oscillation transistor 43. The resonance circuit 44 includes an inductance element 44a, a varactor diode 44b, and the like, and has its one end coupled to the first and second terminals 40a and 40b through two coupling capacitors 48 and 49, respectively. The resonance circuit 44 has the other end grounded.

Therefore, the oscillation circuit 41 forms an unbalanced oscillation circuit. The oscillation frequency is set based on tuning voltage Tu applied to the varactor diode 44b (see for example Japanese Patent Laid-Open No. 2001-257954 (Fig. 1) or US 5 144 263 prior art document (figure 1).

In the above described configuration, the collector of the first oscillation transistor 42 is connected to the power supply and grounded in terms of high frequencies, and the base of the second oscillation transistor is grounded to a ground line in the integrated circuit by the ground capacitor 47. Therefore, the potential difference in terms of high frequencies is caused between the power supply terminal B and the ground line by current passed through the power supply line and the ground line, and the potential difference is applied between the collector of the first oscillation transistor 42 and the base of the second oscillation transistor 43. Consequently, the oscillation operation becomes unstable, which degrades the C/N of the oscillation signal, and parasitic oscillation may result.

It is an object of the invention to stabilize an unbalanced oscillation circuit including two oscillation transistors that are differentially connected and improve the C/N of the oscillation signal.

According to the present invention there is provided an oscillation circuit for a television tuner comprising first and second oscillation transistors differentially connected, and a resonance circuit coupled to said first and second oscillation transistors, wherein the collector of said first oscillation transistor and the base of said second oscillation transistor are grounded for high frequency through a common resistor with a low resistance value to prevent parasitic oscillations, the base of said first oscillation transistor and the collector of said second oscillation transistor are coupled to one end of said resonance circuit through corresponding coupling capacitors , and the other end of said resonance circuit is grounded.

Preferably, said first and second oscillation transistors, said coupling capacitors, and said resistor are provided in the integrated circuit, said resistor is grounded in said integrated circuit, said integrated circuit is provided with a terminal connected to said coupling capacitors, said resonance circuit is provided outside said integrated circuit, and one end of said resonance circuit is connected to said terminal.

An embodiment of the present invention will now be described, by way of example, with reference to the accompanying diagrammatic drawings, in which:
Fig. 1 is a circuit diagram of the configuration of an oscillation circuit for a television tuner.
Fig. 2 is a circuit diagram of the configuration of an oscillation circuit for a television tuner according to an embodiment of the invention.
Fig. 3 is a circuit diagram of the configuration of a conventional oscillation circuit for a television tuner.

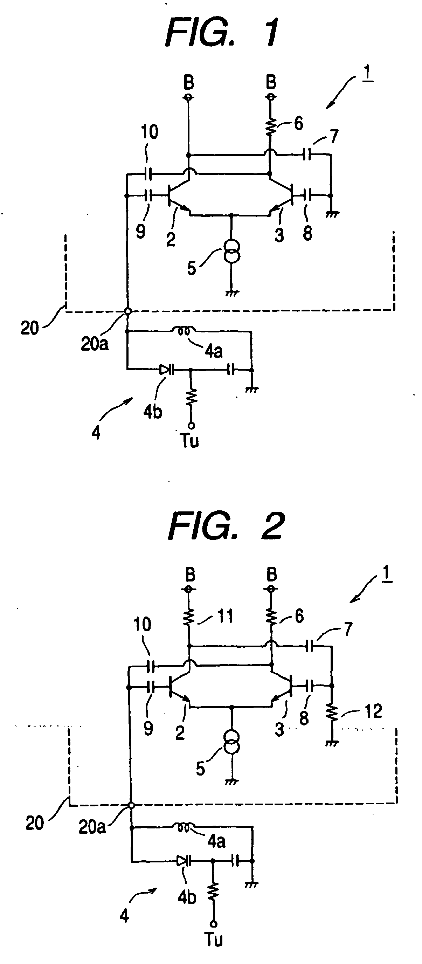

Fig. 1 shows an oscillation circuit 1 for example for use in a VHF television tuner for low or high band and the circuit includes first and second oscillation transistors 2 and 3 provided in an integrated circuit 20 and a resonance circuit 4 provided outside the integrated circuit 20. The first and second oscillation transistors 2 and 3 have their emitters connected with each other and then together to a constant current source 5. The first oscillation transistor 2 has its collector connected to the power supply terminal B of the integrated circuit 20 , and the second oscillation transistor 3 has its collector connected to the power supply terminal B through a feeding resistor 6. The collector of the first oscillation transistor 2 and the base of the second oscillation transistor 3 are grounded in terms of high frequencies to a common grounding point in the integrated circuit 20 by first and second DC cut capacitors 7 and 8, respectively provided in the integrated circuit 20.

The first and second oscillation transistors 2 and 3 are differentially connected, and the base of the first oscillation transistor 2 and the collector of the second oscillation transistor 3 are in phase.

The integrated circuit 20 is provided with a terminal 20a. First and second coupling capacitors 9 and 10 are provided in the integrated circuit 20. The terminal 20a is connected with the base of the first oscillation transistor 2 through the first coupling capacitor 9 and the collector of the second oscillation transistor 3 through the second coupling capacitor 10.

The resonance circuit 4 includes an inductance element 4a, a varactor diode 4b, and the like, and has one end connected to the terminal 20a, and the other end grounded outside the integrated circuit 20.

Therefore, the oscillation circuit 1 forms an unbalanced oscillation circuit. The oscillation frequency is set based on tuning voltage Tu applied to the varactor diode 4b.

In the above described configuration, the collector of the first oscillation transistor 2 and the base of the second oscillation transistor 3 are grounded to the common grounding point, so that the they both attain the same ground potential level in terms of high frequencies, and the oscillation operation is stabilized, which improves the C/N and prevents parasitic oscillation. The base of the first oscillation transistor 2 and the collector of the second oscillation transistor 3 are connected to the terminal 20a through the first and second coupling capacitors 9 and 10, respectively, so that only a single terminal is necessary for connecting the resonance circuit 4. Consequently, the size of the integrated circuit 20 can be small.

In Fig. 2, the same elements as those in Fig. 1 will not be described. The first oscillation transistor 2 has its collector connected to a power supply terminal B through a feeding resistor 11. The feeding resistor 11 is not always necessary. A first DC cut capacitor 7 connected to the collector of the first oscillation transistor 2 is connected to one end of a resistor 12 with a low resistance value, and a second DC cut capacitor 8 connected to the base of a second oscillation transistor 3 is also connected to the end of the resistor 12 with the low resistance value. The other end of the resistor 12 is grounded. The resistor 12 is provided in the integrated circuit 20.

In this configuration, the collector of the first oscillation transistor 2 and the base of the second oscillation transistor 3 attain the same potential level by the resistor 12, and therefore the C/N can effectively be improved. The resistor 12 dumps Q at a resonance circuit 4, and therefore the parasitic oscillation can be prevented even more effectively.

As in the foregoing, according to the invention, the collector of the first oscillation transistor and the base of the second oscillation transistor are grounded in terms of high frequencies to the common grounding point, while the base of the first oscillation transistor and the collector of the second oscillation transistor are coupled to one end of the resonance circuit through corresponding coupling capacitors, and the other end of the resonance circuit is grounded. In this way, the collector of the first oscillation transistor and the base of the second oscillation transistor attain the same ground potential level in terms of high frequencies, and the oscillation operation is stabilized, which improves the C/N and prevents parasitic oscillation.

The first and second oscillation transistors and the coupling capacitors are provided in the integrated circuit, the collector of the first oscillation transistor and the base of the second oscillation transistor are grounded in terms of high frequencies to the grounding point in the integrated circuit. The integrated circuit is provided with a terminal connected to the coupling capacitors, a resonance circuit is provided outside the integrated circuit and one end of the resonance circuit is connected to said terminal. Therefore, only one such terminal to connect the resonance circuit is necessary, and the size of the integrated circuit can be small.

The collector of the first oscillation transistor and the base of the second oscillation transistor are grounded through a common resistor with a low resistance value, the base of the first oscillation transistor and the collector of the second oscillation transistor are coupled to one end of the resonance circuit through corresponding coupling capacitors, the other end of the resonance circuit is grounded, and the resistor dumps Q in the resonance circuit, so that parasitic oscillation can be prevented even more effectively.

The first and second oscillation transistors, the coupling capacitors, and the resistor are provided in the integrated circuit, the resistor is grounded in the integrated circuit, the integrated circuit is provided with a terminal connected with the coupling capacitors, the resonance circuit is provided outside the integrated circuit, and one end of the resonance circuit is connected to the terminal. Therefore, only a single terminal is necessary for connecting the resonance circuit, and the size of the integrated circuit can be small.

## Claims

1. An oscillation circuit for a television tuner comprising first and second oscillation transistors (2,3) differentially connected, and a resonance circuit (4) coupled to said first and second oscillation transistors, wherein the collector of said first oscillation transistor (2) and the base of said second oscillation transistor (3) are grounded for high frequency through a common resistor (12) with a low resistance value to prevent parasitic oscillations, the base of said first oscillation transistor and the collector of said second oscillation transistor are coupled to one end of said resonance circuit through corresponding coupling capacitors (9, 10), and the other end of said resonance circuit is grounded.

2. The oscillation circuit for a television tuner according to claim 1, wherein
said first and second oscillation transistors, said coupling capacitors, and said resistor are provided in an integrated circuit (20), said resistor is grounded in said integrated circuit, said integrated circuit is provided with a terminal (20a) connected to said coupling capacitors, said resonance circuit is provided outside said integrated circuit, and one end of said resonance circuit is connected to said terminal.

## Patentansprüche

1. Oszilfatorschaltung für einen Femsehtuner, umfassend einen ersten und einen zweiten Schwingungstransistor (2, 3), die eine Differenzschaltung bilden, und einen Resonanzkreis (4), der mit dem ersten und dem zweiten Schwingungstransistor gekoppelt ist, wobei der Kollektor des ersten Schwingungstransistors (2) und die Basis des zweiten Schwingungstransis tors (3) hochfrequenzmäßig über einen gemeinsamen Widerstand (12) mit niedrigem Widerstandswert zur Vermeidung parasitärer Schwingungen auf Masse gelegt sind, die Basis des ersten Schwingungstransistors und der Kollektor des zweiten Schwingungstransistors über zugehörige Koppelkondensatoren (9, 10) an ein Ende des Resonanzkreises gekoppelt sind, und das andere Ende des Resonanzkreises auf Masse gelegt ist.

2. Oszillatorschaltung für einen Fernsehtuner gemäß Anspruch 1, bei der erste und der zweite Schwingungstransistor, die Koppelkondensatoren und der Widerstand in einer integrierten Schaltung (20) ausgebildet sind, der Widerstand in der integrierten Schaltung auf Masse gelegt ist, die integrierte Schaltung mit einem Anschluss (20a) versehen ist, der mit den Koppelkondensatoren verbunden ist, der Resonanzkreis sich außerhalb der integrierten Schaltung befindet, und ein Ende des Resonanzkreises mit dem Anschluss verbunden ist.

## Revendications

1. Circuit oscillant pour un sélecteur de canaux comprenant des premier et deuxième transistors d'oscillation (2, 3), reliés de façon différentielle, et un circuit de résonance (4) couplé auxdits premier et deuxième transistors d'oscillation, dans lequel le collecteur dudit premier transistor d'oscillation (2) et la base dudit deuxième transistor d'oscillation (3) sont mis à la terre pour la fréquence élevée, par l'intermédiaire d'une résistance commune (12), ayant une faible valeur de résistance pour empêcher les oscillations parasites, la base dudit premier transistor d'oscillation et le collecteur dudit deuxième transistor d'oscillation sont couplés à une extrémité dudit circuit de résonance, par l'intermédiaire de condensateurs de couplage (9, 10) correspondants, et l'autre extrémité dudit circuit de résonance est mise à la terre.

2. Circuit oscillant pour un sélecteur de canaux selon la revendication 1, dans lequel lesdits premier et deuxième transistors d'oscillation, lesdits condensateurs de couplage, et ladite résistance sont agencés dans un circuit intégré (20), ladite résistance est mise à la terre dans ledit circuit intégré, ledit circuit intégré est doté d'une borne (20a) reliée auxdits condensateurs de couplage, ledit circuit de résonance est agencé à l'extérieur dudit circuit intégré, et une extrémité dudit circuit de résonance est reliée à ladite borne.
